# DEMANDE DE BREVET EUROPEEN

(11) **EP 2 767 810 A1**
(43) Date de publication de la demande: **20.08.2014**
(21) Numéro de dépôt: 14154604.4
(22) Date de dépôt: 11.02.2014
(51) Int. Cl.: G01J 5/02, G01J 5/08, G01J 5/20

(54) **Procédé de réalisation d'un dispositif imageur**

(30) Priorité: 18.02.2013 FR 1351357
(71) Demandeur: Commissariat à l'Énergie Atomique et aux Énergies Alternatives, 75015 Paris (FR)
(72) Inventeur: Dupre, Cécilia, 76240 Bonsecours (FR)
(74) Mandataire: Ilgart, Jean-Christophe

(57) **Abrégé**

Procédé de réalisation d'un dispositif imageur (100) comportant la mise en oeuvre des étapes de :
- réalisation, à travers une couche de matériau électriquement isolant au sein de laquelle sont réalisés un ou plusieurs pixels (110a, 110b) comportant chacun une antenne apte à capter une onde électromagnétique reçue au niveau dudit pixel, d'une ouverture (130) formant un accès à une couche de matériau sacrificiel disposée entre la couche de matériau électriquement isolant et une couche réflectrice (104) apte à réfléchir ladite onde électromagnétique ;
- élimination d'une partie de la couche de matériau sacrificiel à travers l'ouverture, formant entre la couche réflectrice et la couche de matériau électriquement isolant au moins une cavité optique (136).

## Description

### DOMAINE TECHNIQUE

L'invention concerne le domaine des dispositifs imageurs, et en particulier celui des dispositifs imageurs TéraHertz (THz). L'invention s'applique notamment à la réalisation de tels dispositifs imageurs en technologie MOS.

### ÉTAT DE LA TECHNIQUE ANTÉRIEURE

La radiation THz est non-ionisante et est donc considérée comme non dangereuse. Cette radiation est également pénétrante et peut donc être utilisée dans le domaine de l'imagerie médicale ou encore dans le domaine de l'imagerie de sécurité (par exemple dans le but de réaliser une détection d'objets cachés sous des vêtements).

L'imagerie THz est une imagerie passive qui consiste à détecter des ondes émises directement par les éléments observés. Un élément observé émet des ondes différentes selon la température de l'élément qui se comporte, vis-à-vis d'un dispositif imageur THz, comme un corps noir. Ainsi, avec un dispositif imageur THz, il n'est pas nécessaire d'illuminer ou d'irradier ce que l'on souhaite observer ou détecter.

Une technique de réalisation d'un dispositif imageur THz consiste à réaliser les différents éléments du dispositif imageur en technologie CMOS sur un substrat semi-conducteur, puis de mettre en oeuvre des étapes dites de post-processing, ou post-traitement, afin d'isoler thermiquement les détecteurs, ou capteurs, des pixels du dispositif imageur.

Chaque pixel du dispositif imageur comporte par exemple une antenne thermique, c'est-à-dire une antenne qui capte une radiation électromagnétique et qui la convertit en chaleur. Cette variation de température est alors détectée par le capteur du pixel, ce capteur pouvant être par exemple un bolomètre, une diode ou un transistor MOS (fonctionnant par exemple en régime sous-seuil), comme décrit par exemple dans le document WO 2011/151756 A2. Le capteur est dans ce cas un capteur thermique apte à convertir une variation de température émise par l'antenne en une variation électrique d'un signal.

En variante, il est possible que l'antenne d'un pixel du dispositif imageur soit couplée de manière capacitive à un élément résistif qui émet une chaleur dont l'intensité est fonction de la radiation électromagnétique détectée par l'antenne. Cette variation de température est alors détectée par le capteur du pixel, comme décrit dans le document WO 2011/048170 A1.

Le document WO 2010/076783 A1 décrit en outre la mise en oeuvre d'étapes de post-processing à partir de puces unitaires pour réaliser des dispositifs imageurs THz.

Afin d'augmenter l'efficacité de l'antenne réceptrice, il est proposé dans le document WO 2011/151756 A2 de rajouter, sous l'antenne de chaque pixel du dispositif imageur, un réflecteur d'ondes électromagnétiques disposé à une distance égale à λ/4 par rapport à l'antenne, avec λ correspondant à la longueur d'onde incidente destinée à être détectée par l'antenne. La réalisation d'un tel réflecteur est toutefois complexe et coûteuse à mettre en oeuvre.

### EXPOSÉ DE L'INVENTION

Un but de la présente invention est de proposer un procédé de réalisation d'un dispositif imageur comportant des réflecteurs d'onde électromagnétique couplés aux pixels du dispositif imageur, qui soit moins complexe et coûteux à mettre en oeuvre que les procédés de l'art antérieur.

Pour cela, la présente invention propose un procédé de réalisation d'un dispositif imageur comportant au moins la mise en oeuvre des étapes de :
- réalisation, à travers au moins une couche de matériau électriquement isolant, ou diélectrique, au sein de laquelle sont réalisés un ou plusieurs pixels comportant chacun au moins une antenne apte à capter au moins une onde électromagnétique reçue au niveau dudit pixel, d'au moins une ouverture formant un accès à au moins une couche de matériau sacrificiel disposée entre la couche de matériau électriquement isolant et au moins une couche réflectrice apte à réfléchir ladite onde électromagnétique ;
- élimination d'au moins une partie de la couche de matériau sacrificiel à travers l'ouverture, formant entre la couche réflectrice et la couche de matériau électriquement isolant au moins une cavité optique.

Ce procédé selon l'invention propose donc de faire appel à un substrat comportant une couche réflectrice enterrée aisément accessible via la gravure d'une couche de matériau sacrificiel disposée sous le ou les pixels du dispositif imageur. La couche réflectrice peut alors former le ou les réflecteurs couplés optiquement au(x) pixel(s) du dispositif imageur.

La couche réflectrice et la couche de matériau électriquement isolant peuvent être espacées d'une distance égale à environ λ/4n, avec n correspondant à l'indice de réfraction d'un milieu dans la cavité optique, et λ correspondant à la longueur d'onde de l'onde électromagnétique. Ce procédé permet ainsi de contrôler aisément la distance entre la couche réflectrice et le ou les pixels du fait que cette distance de λ/4n peut être définie en contrôlant l'épaisseur de la couche de matériau sacrificiel. Une telle distance permet d'avoir une cavité optique dans laquelle se produit des interférences constructives au niveau de l'antenne du ou des pixels. Cette distance peut être obtenue en réalisant la couche de matériau sacrificiel telle que son épaisseur soit égale à environ λ/4n.

L'antenne du ou de chaque pixel peut être couplée à au moins un capteur électronique dudit pixel.

Le capteur électronique du ou de chaque pixel peut comporter au moins un bolomètre, ou une diode ou un transistor, par exemple de type MOS.

Le procédé peut comporter en outre, préalablement à la réalisation de l'ouverture à travers la couche de matériau électriquement isolant, la réalisation du ou des pixels en technologie MOS.

La couche de matériau électriquement isolant peut comporter un empilement de plusieurs couches isolantes intercouches (ILD, ou diélectriques intercouches). Ces couches ILD peuvent recouvrir les différents éléments semi-conducteurs et métalliques du ou des pixels réalisés en technologie MOS.

Le procédé peut comporter en outre, entre la réalisation du ou des pixels et la réalisation de l'ouverture à travers la couche de matériau électriquement isolant, la réalisation de plusieurs niveaux de matériau électriquement conducteur, par exemple des niveaux de métal, entre les couches isolantes intercouches telles que des portions d'au moins un des niveaux de matériau électriquement conducteur forment des masques protégeant le ou les pixels lors de la réalisation de l'ouverture à travers la couche de matériau électriquement isolant. Ainsi, l'étape permettant d'accéder à la couche de matériau sacrificiel permet en outre de définir géométriquement le ou les pixels du dispositif imageur.

Le ou les pixels peuvent être réalisés sur un substrat à base du matériau sacrificiel, et le procédé peut comporter en outre, entre la réalisation du ou des pixels et la réalisation de l'ouverture à travers la couche de matériau électriquement isolant, la mise en oeuvre des étapes de :
- solidarisation d'une poignée mécanique à une première face de la couche de matériau électriquement isolant opposée à une seconde face de la couche de matériau électriquement isolant à laquelle le substrat est solidarisé ;
- amincissement du substrat tel qu'une portion restante d'épaisseur égale à environ λ/4n forme la couche de matériau sacrificiel ;
- réalisation de la couche réflectrice et d'un second substrat contre la couche de matériau sacrificiel tels que la couche réflectrice soit disposée entre la couche de matériau sacrificiel et le second substrat ;
- suppression de la poignée mécanique.

Selon une variante, le ou les pixels peuvent être réalisés sur un substrat, et le procédé peut comporter en outre, entre la réalisation du ou des pixels et la réalisation de l'ouverture à travers la couche de matériau électriquement isolant, la mise en oeuvre des étapes de :
- solidarisation d'une poignée mécanique à une première face de la couche de matériau électriquement isolant opposée à une seconde face de la couche de matériau électriquement isolant à laquelle le substrat est solidarisé ;
- élimination du substrat ;
- réalisation de la couche de matériau sacrificiel d'épaisseur égale à environ λ/4n, de la couche réflectrice et d'un second substrat contre la seconde face de la couche de matériau électriquement isolant, tels que la couche de matériau sacrificiel soit disposée entre la couche réflectrice et la couche de matériau électriquement isolant et que la couche réflectrice soit disposée entre la couche de matériau sacrificiel et le second substrat ;
- suppression de la poignée mécanique.

La couche de matériau électriquement isolant peut être à base d'oxyde de semi-conducteur, par exemple du SiO₂, et la couche de matériau sacrificiel peut être solidarisée à la couche de matériau électriquement isolant par l'intermédiaire d'une deuxième couche de matériau électriquement isolant à base d'oxyde de semi-conducteur formée au préalable contre la couche de matériau de matériau sacrificiel.

Le procédé peut comporter en outre, préalablement à la réalisation de l'ouverture à travers la couche de matériau électriquement isolant, la réalisation d'un masque de gravure sur la couche de matériau électriquement isolant tel que des portions du masque de gravure recouvrent des plots de connexion reliés électriquement au ou aux pixels.

Le procédé peut comporter en outre, après l'élimination d'au moins une partie de la couche de matériau sacrificiel à travers l'ouverture, le remplissage de la cavité optique par au moins un gaz ou un matériau d'indice de réfraction égal à n, formant un milieu de la cavité optique.

Le matériau sacrificiel peut être du silicium et/ou du germanium, et/ou dans lequel la couche de matériau électriquement isolant peut être à base d'oxyde de semi-conducteur.

La couche réflectrice peut comporter un empilement d'au moins une couche d'arrêt de gravure à base d'un matériau apte à résister à un agent de gravure utilisé lors de l'élimination d'au moins une partie de la couche de matériau sacrificiel et d'au moins une couche réfléchissante, la couche d'arrêt de gravure étant disposée entre la couche réfléchissante et la couche de matériau sacrificiel.

La couche réfléchissante est avantageusement métallique, mais peut également être à base de silicium.

La couche d'arrêt de gravure peut être à base d'oxyde de semi-conducteur et/ou la couche réfléchissante peut être à base d'aluminium.

L'onde électromagnétique peut comporter une longueur d'onde λ comprise entre environ 0,5 THz et 10 THz, ou comprise avantageusement entre environ 0,5 THz et 1,5 THz.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1D représentent des étapes d'un procédé de réalisation d'un dispositif imageur, objet de la présente invention, selon un premier mode de réalisation ;
- les figures 2A à 2D représentent une partie des étapes d'un procédé de réalisation d'un dispositif imageur, objet de la présente invention, selon un deuxième mode de réalisation ;
- les figures 3A à 3D représentent une partie des étapes d'un procédé de réalisation d'un dispositif imageur, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

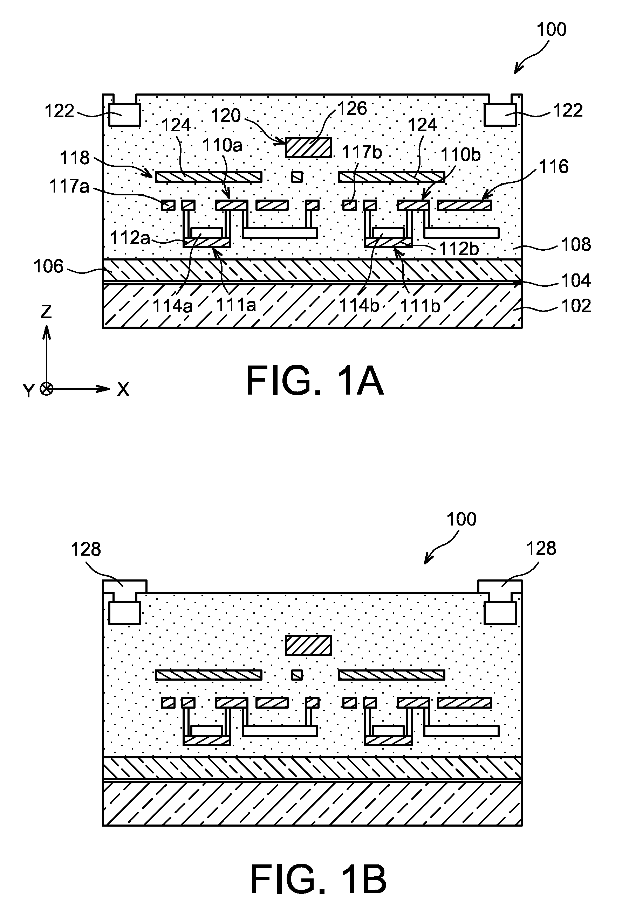

On se réfère aux figures 1A à 1D qui représentent des étapes d'un procédé de réalisation d'un dispositif imageur THz 100 selon un premier mode de réalisation.

Le dispositif imageur 100 comporte un substrat 102, ou wafer, à base de semi-conducteur, par exemple du silicium. Une couche réflectrice 104, destinée à former des réflecteurs d'ondes électromagnétiques sous un réseau de pixels du dispositif imageur 100, est disposée sur le substrat 102. Dans ce premier mode de réalisation, la couche réflectrice 104 correspond à un bicouche oxyde/métal, formé par exemple d'une couche d'aluminium recouverte par une couche de SiO₂, et dont la couche réfléchissante, ici métallique, est en contact avec le substrat 102. En variante, la couche réflectrice 104 peut correspondre à une alternance de couches métalliques gravées (par exemple de l'aluminium) et de couches diélectriques (par exemple de l'oxyde tel que du SiO₂), augmentant la gamme des longueurs d'ondes électromagnétiques pouvant être réfléchies par cette couche réflectrice 104. Il est également possible que la couche réflectrice 104 soit formée d'une unique couche de matériau apte à réaliser à la fois une fonction de réflexion d'ondes électromagnétiques et une fonction d'arrêt de gravure (lors de la gravure d'une couche de matériau sacrificiel 106 disposée sur la couche réflectrice 104, comme décrit plus loin), par exemple composée d'aluminium, une gravure de type XeF₂ pouvant servir à graver du silicium dont est composée la couche de matériau sacrificiel 106 sans attaquer l'aluminium.

La couche de matériau sacrificiel 106, par exemple à base de semi-conducteur tel que du silicium ou du germanium, est déposée sur la couche réflectrice 104. De manière générale, le matériau de la couche sacrificielle 106 est choisi tel qu'il puisse être gravé sélectivement vis-à-vis du matériau de la couche réflectrice 104 se trouvant en contact avec le matériau sacrificiel (par exemple vis-à-vis de l'oxyde lorsque la couche réflectrice 104 est formée par un bicouche oxyde/métal) et des éventuels autres matériaux se trouvant en contact avec des parties de la couche de matériau sacrificiel 106 destinées à être gravées ultérieurement.

La couche de matériau sacrificiel 106 est recouverte d'une couche de matériau électriquement isolant 108 telle qu'une couche diélectrique, par exemple composée de SiO₂, au sein de laquelle est réalisé notamment le réseau de pixels du dispositif imageur 100. Sur les figures 1A à 1D, seuls deux pixels 110a et 110b sont représentés. Chacun des pixels 110a, 110b comporte un capteur 111a, 111b correspondant par exemple à un bolomètre, une diode, ou encore un transistor. Dans le premier mode de réalisation décrit ici, chaque capteur 111a, 111b, comporte un transistor de type MOS comprenant notamment une portion 112a, 112b d'une couche active de semi-conducteur (par exemple de silicium) dont une partie (formant le canal de chaque transistor) est recouverte par une grille 114a, 114b, ici à base de polysilicium. Un premier niveau de matériau électriquement conducteur 116, correspondant ici à un premier niveau de métal (généralement appelé METAL 1 ou M1), est formé dans la couche diélectrique 108, au-dessus des transistors MOS des capteurs 111a, 111b. Ce premier niveau de métal 116 est obtenu en gravant une couche métallique par exemple à base d'aluminium ou de tungstène, les portions restantes de cette couche métallique formant le premier niveau de métal 116. Des portions métalliques de ce premier niveau de métal 116 forment, dans chaque pixel 110a, 110b, une antenne 117a, 117b reliée électriquement au capteur 111a, 111b du pixel 110a, 110b, par l'intermédiaire d'un ou plusieurs vias métalliques.

Ainsi, chaque pixel du dispositif imageur 100 comprend une antenne apte à transformer une onde électromagnétique reçue en chaleur ou en courant électrique. La variation de chaleur ou de courant électrique est ensuite détectée par le capteur qui est couplé à l'antenne.

Un deuxième et un troisième niveaux de matériau électriquement conducteur, ici des niveaux de métal (appelés METAL 2, ou M2, et METAL 3, ou M3), respectivement référencés 118 et 120, sont également formés dans la couche diélectrique 108, au-dessus du premier niveau de métal 116. Chacun des deux niveaux de métal 118 et 120 est par exemple réalisé à partir d'une couche métallique gravée à base d'aluminium. Chacune des portions métalliques des niveaux de métal 116, 118 et 120 a par exemple une épaisseur comprise entre environ 200 nm et 500 nm.

Enfin, des plots de connexion 122 sont également réalisés dans la couche diélectrique 108, en périphérie des pixels 110a, 110b afin de ne pas interférer dans la réception des ondes électromagnétiques par les pixels 110a, 110b. Ces plots 122 sont par exemple obtenus à partir d'une couche métallique d'épaisseur égale à quelques microns (par exemple 4 µm) à base d'aluminium. Les plots de connexion 122 sont notamment reliés électriquement aux sorties des capteurs 111a, 111b des pixels 110a, 110b via des portions des différents niveaux de métal 116, 118 et 120. Des liaisons électriques entre les différents niveaux de métal 116, 118, 120 et avec les capteurs 111a, 111b et les plots de connexion 122 sont réalisées par des vias électriquement conducteurs réalisés dans la couche diélectrique 108.

Sur les figures 1A à 1D, la couche diélectrique 108 est représentée de manière schématique comme étant une unique couche de matériau électriquement isolant. En réalité, cette couche 108 est formée par la superposition de plusieurs couches de matériau électriquement isolant déposées successivement lors de la réalisation des pixels, recouvrant les différents éléments des pixels et des niveaux de métal. La couche 108 est ainsi formée par la superposition de plusieurs couches isolantes intercouches appelées ILD (« Inter Layer Dielectric »). L'épaisseur (dimension selon l'axe Z représenté sur la figure 1A) de la couche diélectrique 108 est par exemple égale à environ 14 µm.

Les différents éléments du réseau de pixels décrits ci-dessus sont par exemple réalisés en mettant en oeuvre des étapes de dépôt, photolithographie et gravure de différentes couches de matériaux, correspondant à un procédé de réalisation de type MOS.

Outre la fonction d'interconnexion électrique remplie par certaines portions des niveaux de métal 116, 118 et 120, le deuxième niveau de métal 118 est réalisé tel que des portions restantes 124 de ce deuxième niveau de métal 118 forment chacune un masque de gravure, protégeant le capteur 111a, 111b et l'antenne 117a, 117b de chaque pixel 110a, 110b lors d'une gravure qui sera mise en oeuvre ultérieurement pour graver une partie de la couche diélectrique 108. De même, le troisième niveau de métal 120 est réalisé tel que des portions restantes 126 forment un masque de gravure protégeant notamment des portions de la couche diélectrique 108, du deuxième niveau de métal 118 et du premier niveau de métal 116 (et éventuellement d'autres matériaux ayant servis à la réalisation des capteurs) destinées à former, dans chaque pixel 110a, 110b, un cadre assurant le maintien mécanique de l'antenne 117a, 117b et du capteur 111a, 111b du pixel 110a, 110b. Des portions du premier niveau de métal 116 peuvent également servir de masque de gravure pour des portions de matériaux (silicium, polysilicium, diélectrique, etc.) se trouvant sous celles-ci. Sur l'exemple de la figure 1A, pour chaque pixel 110a, 110b, des portions de la couche diélectrique 108 et de polysilicum sont protégées par une portion du premier niveau de métal 116 afin qu'après la gravure, ces portions de matériaux, ou bras, relient mécaniquement le cadre à l'ensemble comportant l'antenne et le capteur.

Bien que non représenté sur les figures 1A-1D, le dispositif imageur 100 peut comporter également un circuit de lecture de signaux destinés à être délivrés par les capteurs des pixels du dispositif imageur 100, réalisé au niveau du réseau de pixels. Ce circuit de lecture peut être réalisé par exemple en technologie CMOS. Dans ce cas, il peut être réalisé en même temps que les différents niveaux de métal (M1, M2, ...). Ce circuit de lecture peut être réalisé à côté des pixels, sous les plots de connexion 122 ou à côté de ces plots.

Comme représenté sur la figure 1B, des portions de résine 128 sont déposées telles qu'elles recouvrent et protègent les plots de connexions 122 vis-à-vis de la future gravure. Si le circuit de lecture est réalisé à côté des plots de connexion 122, il peut alors être également protégé par la résine 128.

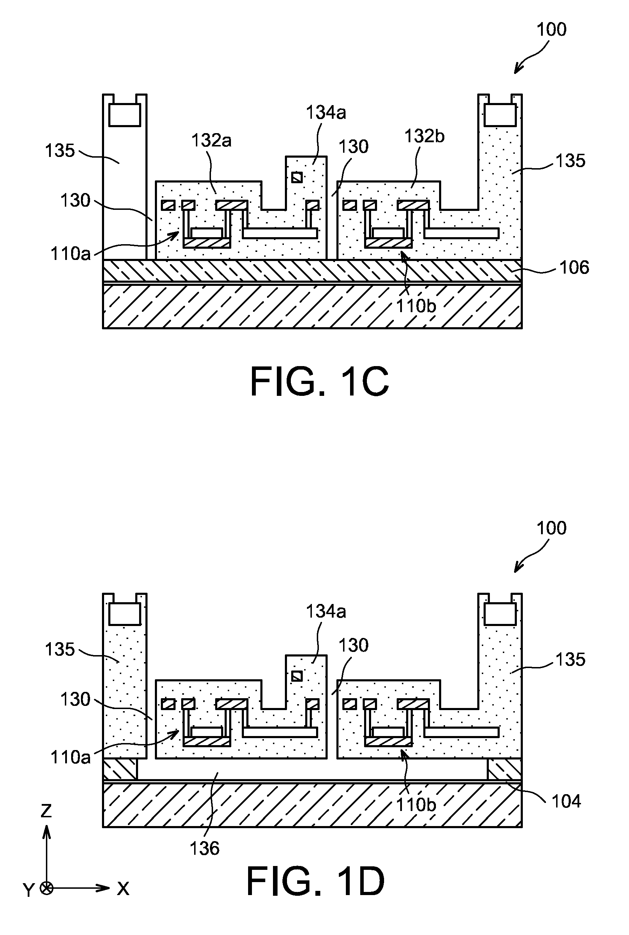

On réalise ensuite la gravure de la couche diélectrique 108, par exemple via une gravure de type C₄F₈ (figure 1C). Au niveau des zones de la couche diélectrique 108 non protégées par des portions métalliques formées par l'un des niveaux de métal dans la couche diélectrique 108 ou par les portions de résine 128, la couche diélectrique 108 est alors gravée sur toute son épaisseur, révélant ainsi des parties de la couche de matériau sacrificiel 106. Cette gravure permet donc de réaliser des ouvertures à travers la couche diélectrique 108 formant des accès à la couche de matériau sacrificiel 106. Des tranchées 130 formées à travers toute l'épaisseur de la couche diélectrique 108 définissent également géométriquement le matériau diélectrique 132a, 132b conservé pour les pixels de l'imageur 100. Sur la figure 1C, un cadre 134a du pixel 110a est également représenté. Des portions de matériau diélectrique 135 sont également conservées sous les plots 122, formant le cadre de l'ensemble de pixels, c'est-à-dire le cadre de l'imageur 100. Au niveau des zones protégées par des portions des niveaux de métal, seule l'épaisseur de matériau diélectrique de la couche 108 se trouvant au-dessus de ces portions métalliques est gravée. Les antennes 117a, 117b se retrouvent bien encapsulées dans le matériau diélectrique restant en raison de la protection réalisée par les portions métalliques 124 lors de la gravure.

Les portions de résine 128 ainsi que les portions métalliques révélées par la gravure, c'est-à-dire les portions métalliques ayant servies de masques de gravure, sont ensuite supprimées, par exemple via la mise en oeuvre d'une autre gravure adaptée aux matériaux à supprimer.

Comme représenté sur la figure 1D, on grave alors partiellement la couche de matériau sacrificiel 106 via les tranchées ou ouvertures 130 (partiellement car des parties de la couche de matériau sacrificiel 106 ne se trouvant pas en regard des pixels sont conservées, notamment les parties de la couche de matériau sacrificiel se trouvant en regard des plot de connexion 122, sous les portions 135 de matériau diélectrique), révélant ainsi les parties de la couche réflectrice 104 se trouvant sous les pixels 110a, 110b et formant un réflecteur sous chacun des pixels 110a, 110b du dispositif imageur 100. La couche réflectrice 104, destinée à former des réflecteurs vis-à-vis des pixels du dispositif imageur 100, sert également de couche d'arrêt de gravure lors de la gravure de la couche de matériau sacrificiel 106. Lorsque la couche réflectrice 104 correspond à un bicouche oxyde/métal, la partie de ce bicouche composée d'oxyde et qui se trouve au-dessus de la partie composée de métal sert ainsi de couche d'arrêt de gravure. De manière générale, le matériau de la couche réflectrice 104 qui forme la partie supérieure de cette couche est choisi tel qu'il forme un matériau d'arrêt à la gravure vis-à-vis du matériau sacrificiel de la couche 106. La gravure mise en oeuvre pour supprimer le matériau sacrificiel de la couche 106 correspond par exemple à une gravure isotrope. Lorsque la couche de matériau sacrificiel 106 est à base de silicium, cette gravure isotrope peut correspondre à une gravure sèche et chimique de type XeF₂, CF₄ ou encore SF₆, ou bien correspondre à une gravure humide de type TMAH.

La gravure de la couche de matériau sacrificiel 106 forme, entre la couche réflectrice 104 et les pixels 110a, 110b du dispositif imageur 100, une cavité optique 136. L'épaisseur, ou la hauteur, de la cavité optique 136, correspondant à la dimension de la cavité optique 136 selon l'axe Z représenté sur la figure 1D, correspond à l'épaisseur de la couche de matériau sacrificiel 106 gravée.

Dans l'exemple décrit en liaison avec les figures 1A à 1D, le volume formé par la cavité optique 136 est laissé vide. En variante, il est possible qu'après la gravure de la couche de matériau sacrificiel 106, la cavité optique 136 soit remplie par un matériau, sous forme solide, ou liquide et/ou gazeux, transparent à la longueur d'onde incidente destinée à être détectée par le dispositif imageur 100. Ce matériau peut être un isolant, un semi-conducteur, un matériau organique ou du vide, comme décrit par exemple dans le document WO2010/007266 A1.

La couche de matériau sacrificiel 106 est réalisée avec une épaisseur telle que la distance entre la couche réflectrice 104 et les antennes 117a, 117b soit égale à environ λ/4n, avec n correspondant à l'indice du milieu (matériau et/ou gaz) se trouvant dans la cavité optique 136 (soit n égal à environ 1 lorsque la cavité 136 n'est pas remplie par un matériau après la gravure de la couche de matériau sacrificiel 106, et donc que de l'air est présent dans la cavité optique 136, comme c'est le cas sur la figure 1D), et λ correspondant à la longueur d'onde incidente destinée à être détectée par le dispositif imageur 100. Ainsi, la couche réflectrice 104 forme des réflecteurs d'ondes électromagnétiques disposés à une distance de λ/4n des pixels du dispositif imageur 100.

Cette distance entre les antennes et la couche réflectrice peut être approximée en réalisant la couche réflectrice 104 et la couche diélectrique 108 telles qu'elles soient espacées l'une de l'autre de la distance égale à environ λ/4n, en réalisant pour cela la couche de matériau sacrificiel 106 telle que son épaisseur soit égale à environ λ/4n. En effet, du fait que la hauteur de la cavité optique 136 (dimension selon l'axe Z), correspondant à l'épaisseur de la couche de matériau sacrificiel 106 et par exemple égale à environ 75 µm, est bien supérieure (par exemple au moins d'un facteur 10) à l'épaisseur de matériau diélectrique, par exemple d'environ 1 µm, se trouvant entre les antennes 117a, 117b et la couche de matériau sacrificiel 106, le déphasage induit par cette épaisseur de matériau diélectrique sur l'onde électromagnétique incidente est négligeable par rapport au déphasage de la cavité optique 136.

Dans ce premier mode de réalisation, les étapes précédemment décrites en liaison avec les figures 1A-1D sont mises en oeuvre à partir d'un substrat de silicium comportant, préalablement à la réalisation des pixels 110a, 110b, les couches de silicium 102 et 106 et la couche réflectrice 104 enterrée. Toutefois, il est également possible de réaliser un tel substrat après la réalisation des pixels 110a, 110b, comme décrit ci-dessous en liaison avec le deuxième et le troisième modes de réalisation.

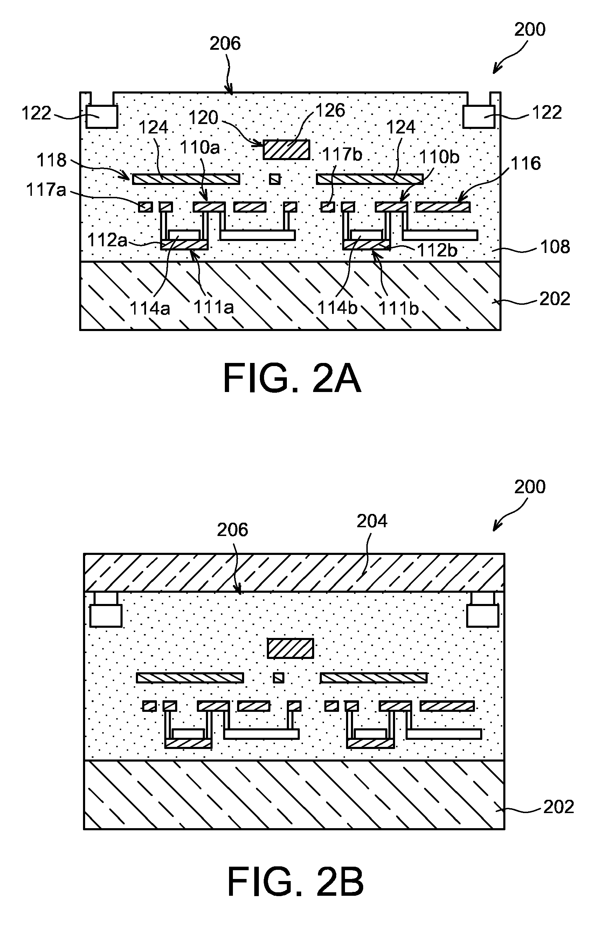

Les figures 2A à 2D représentent des étapes d'un procédé de réalisation d'un dispositif imageur 200 selon un deuxième mode de réalisation.

Comme représenté sur la figure 2A, les éléments 108 à 126 précédemment décrits en liaison avec la figure 1A sont réalisés sur un substrat 202, ou wafer, de type bulk, par exemple composé de semi-conducteur tel que du silicium et d'épaisseur égale à plusieurs centaines de microns, par exemple comprise entre environ 500 µm et 700 µm.

Une poignée mécanique 204, correspondant par exemple à un autre substrat, ou wafer, de semi-conducteur ou encore de verre, est solidarisée à une face supérieure 206 de la couche diélectrique 108 (figure 2B).

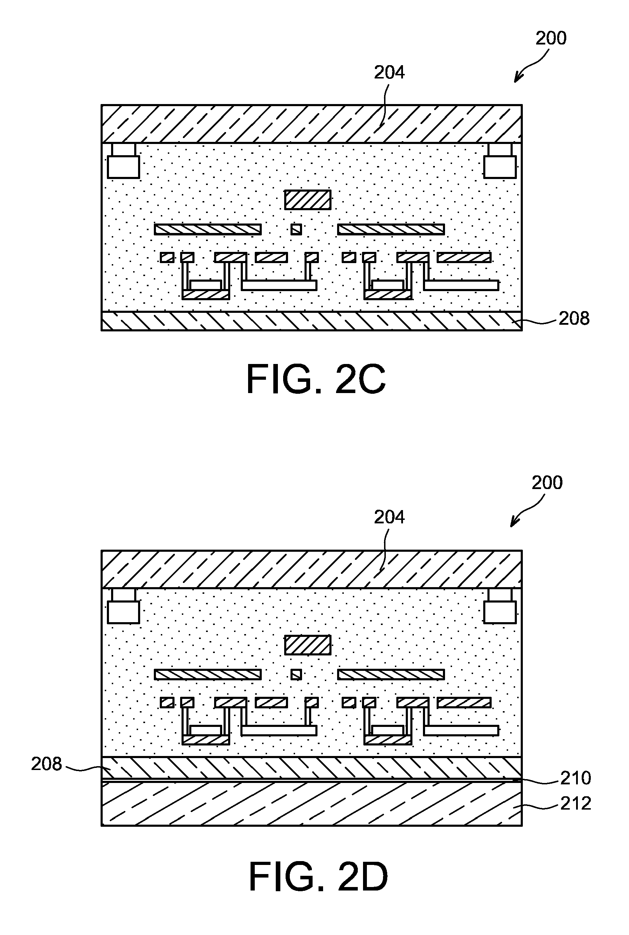

Comme représenté sur la figure 2C, le substrat 202 est ensuite aminci tel qu'une portion restante de ce substrat 202 forme une couche de matériau sacrificiel 208 dont l'épaisseur correspond à l'espace souhaité entre les pixels de l'imageur 200 et les réflecteurs destinés à être réalisés par la suite, par exemple égale à celle de la couche de matériau sacrificiel 106 précédemment décrite dans le premier mode de réalisation. La couche de matériau sacrificiel 208 ainsi réalisée est similaire à la couche de matériau sacrificiel 106 précédemment décrite en liaison avec le premier mode de réalisation. Lors de cette étape d'amincissement, la poignée mécanique 204 assure le maintien mécanique de l'ensemble des éléments du dispositif imageur 200. L'amincissement peut être réalisé par abrasion mécanique.

Enfin, un autre substrat, ou wafer, bulk 212, sur lequel une couche réflectrice 210, par exemple métallique et pouvant être similaire à la couche réflectrice 104 précédemment décrite, est réalisée, est solidarisé à la couche de matériau sacrificiel 208 tel que la couche réflectrice 210 soit disposée contre la couche de matériau sacrificiel 208 (figure 2D).

La poignée mécanique 204 est ensuite retirée et la réalisation du dispositif imageur 200 est achevée en mettant en oeuvre des étapes similaires à celles précédemment décrites en liaison avec les figures 1A à 1D, c'est-à-dire des étapes de masquage et gravure de la couche diélectrique 108, définissant la géométrie des pixels du dispositif imageur 200 et formant des accès à la couche de matériau sacrificiel 208, puis la gravure d'une partie de la couche de matériau sacrificiel 208 afin de révéler la couche réflectrice 210 qui forme alors des réflecteurs associés aux pixels du dispositif imageur 200.

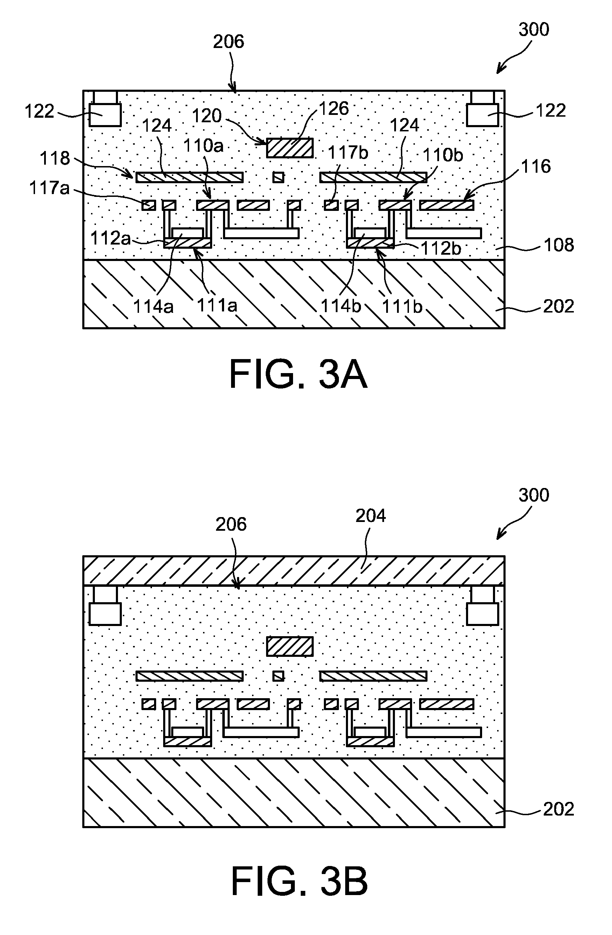

Les figures 3A à 3D représentent des étapes d'un procédé de réalisation d'un dispositif imageur 300 selon un troisième mode de réalisation.

Comme représenté sur la figure 3A, les éléments 108 à 126 précédemment décrits en liaison avec la figure 1A sont réalisés sur un substrat 202, par exemple similaire à celui précédemment décrit en liaison avec la figure 2A. Toutefois, dans ce troisième mode de réalisation, le substrat utilisé peut être à base d'un matériau autre que le matériau sacrificiel destiné à former la couche sacrificielle qui recouvrira la couche réflectrice.

Comme dans le deuxième mode de réalisation, une poignée mécanique 204, correspondant par exemple à un deuxième substrat, ou wafer, de semi-conducteur ou encore de verre, est solidarisé à une face supérieure 206 de la couche diélectrique 108 (figure 3B).

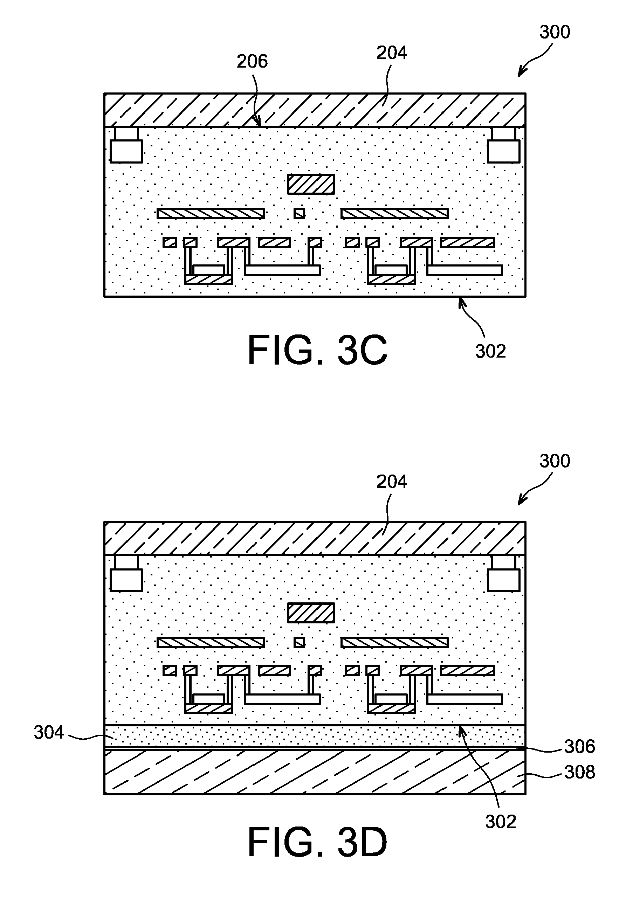

Comme représenté sur la figure 3C, le substrat 202 est ensuite aminci totalement, autrement dit supprimé, révélant ainsi une face arrière 302 de la couche diélectrique 108. Lors de cette étape, la poignée mécanique 204 assure le maintien mécanique de l'ensemble des éléments du dispositif imageur 300. Le substrat 202 peut être supprimé en mettant en oeuvre une première étape d'abrasion supprimant une majeure partie du substrat 202, le matériau restant du substrat 202 pouvant être éliminé par une gravure humide de type TMAH.

Un autre wafer comportant notamment une couche de matériau sacrificiel 304, par exemple de nature et de dimensions similaires aux couches de matériau sacrificiel 106 et 208 précédemment décrites, est solidarisé contre la face arrière 302 de la couche diélectrique 108 via par exemple un collage oxyde-oxyde (une couche d'oxyde est donc formée, préalablement au collage, sur la couche de matériau sacrificiel 304). Cet autre wafer comporte en outre une couche réflectrice 306, par exemple métallique et pouvant être similaire aux couches réflectrices 104 et 210 précédemment décrites, disposée contre la couche de matériau sacrificiel 304, ainsi qu'un substrat, ou couche épaisse, 308 par exemple à base de silicium et solidarisé à la couche réflectrice 306, assurant le maintien mécanique de l'ensemble (figure 3D).

La poignée mécanique 204 est ensuite retirée et la réalisation du dispositif imageur 300 est achevée en mettant en oeuvre des étapes similaires à celles précédemment décrites en liaison avec les figures 1A à 1D, c'est-à-dire des étapes de masquage et gravure de la couche diélectrique 108, définissant la géométrie des pixels du dispositif imageur 300 et formant des accès à la couche de matériau sacrificiel 304, puis la gravure d'une partie de la couche de matériau sacrificiel 304 afin de révéler une partie de la couche réflectrice 306 qui forme des réflecteurs associés aux pixels du dispositif imageur 300.

Les procédés précédemment décrits sont particulièrement adaptés à la réalisation de dispositifs imageurs THz fonctionnant par exemple dans la gamme des longueurs d'ondes comprise entre environ 0,5 THz et 10 THz, et avantageusement entre environ 0,5 THz et 1,5 THz.

## Revendications

1. Procédé de réalisation d'un dispositif imageur (100, 200, 300) comportant au moins la mise en oeuvre des étapes de :
- réalisation, à travers au moins une couche de matériau électriquement isolant (108) au sein de laquelle sont réalisés un ou plusieurs pixels (110a, 110b) comportant chacun au moins une antenne (117a, 117b) apte à capter au moins une onde électromagnétique reçue au niveau dudit pixel (117a, 117b), d'au moins une ouverture (130) formant un accès à au moins une couche de matériau sacrificiel (106, 208, 304) disposée entre la couche de matériau électriquement isolant (108) et au moins une couche réflectrice (104, 210, 306) apte à réfléchir ladite onde électromagnétique ;
- élimination d'au moins une partie de la couche de matériau sacrificiel (106, 208, 304) à travers l'ouverture (130), formant entre la couche réflectrice (104, 210, 306) et la couche de matériau électriquement isolant (108) au moins une cavité optique (136).

2. Procédé selon la revendication 1, dans lequel la couche réflectrice (104, 210, 306) et la couche de matériau électriquement isolant (108) sont espacés d'une distance égale à environ λ/4n, avec n correspondant à l'indice de réfraction d'un milieu dans la cavité optique (136), et λ correspondant à la longueur d'onde de l'onde électromagnétique.

3. Procédé selon l'une des revendications précédentes, dans lequel l'antenne du ou de chaque pixel est couplée à au moins un capteur électronique (111a, 111b)) dudit pixel (110a, 110b).

4. Procédé selon la revendication 3, dans lequel le capteur électronique (111a, 111b) du ou de chaque pixel (110a, 110b) comporte au moins un bolomètre, ou une diode ou un transistor (112a, 112b, 114a, 114b).

5. Procédé selon l'une des revendications précédentes, comportant en outre, préalablement à la réalisation de l'ouverture (130) à travers la couche de matériau électriquement isolant (108), la réalisation du ou des pixels (110a, 110b) en technologie MOS.

6. Procédé selon la revendication 5, dans lequel la couche de matériau électriquement isolant (108) comporte un empilement de plusieurs couches isolantes intercouches.

7. Procédé selon la revendication 6, comportant en outre, entre la réalisation du ou des pixels (110a, 110b) et la réalisation de l'ouverture (130) à travers la couche de matériau électriquement isolant (108), la réalisation de plusieurs niveaux de matériau électriquement conducteur (116, 118, 120) entre les couches isolantes intercouches telles que des portions (124, 126) d'au moins un des niveaux de matériau électriquement conducteur (116, 118, 120) forment des masques protégeant le ou les pixels (110a, 110b) lors de la réalisation de l'ouverture (130) à travers la couche de matériau électriquement isolant (108).

8. Procédé selon l'une des revendications 5 à 7, dans lequel le ou les pixels (110a, 110b) sont réalisés sur un substrat (202) à base du matériau sacrificiel, et le procédé comporte en outre, entre la réalisation du ou des pixels (110a, 110b) et la réalisation de l'ouverture (130) à travers la couche de matériau électriquement isolant (108), la mise en oeuvre des étapes de :
- solidarisation d'une poignée mécanique (204) à une première face (206) de la couche de matériau électriquement isolant (108) opposée à une seconde face de la couche de matériau électriquement isolant (108) à laquelle le substrat (202) est solidarisé ;
- amincissement du substrat (202) tel qu'une portion restante d'épaisseur égale à environ λ/4n forme la couche de matériau sacrificiel (208) ;
- réalisation de la couche réflectrice (210) et d'un second substrat (212) contre la couche de matériau sacrificiel (208) tels que la couche réflectrice (210) soit disposée entre la couche de matériau sacrificiel (208) et le second substrat (212);
- suppression de la poignée mécanique (204).

9. Procédé selon l'une des revendications 5 à 7, dans lequel le ou les pixels sont réalisés sur un substrat (202), et le procédé comporte en outre, entre la réalisation du ou des pixels (110a, 110b) et la réalisation de l'ouverture (130) à travers la couche de matériau électriquement isolant (108), la mise en oeuvre des étapes de :
- solidarisation d'une poignée mécanique (204) à une première face (206) de la couche de matériau électriquement isolant (108) opposée à une seconde face (302) de la couche de matériau électriquement isolant (108) à laquelle le substrat (202) est solidarisé ;
- élimination du substrat (202) ;
- réalisation de la couche de matériau sacrificiel (304) d'épaisseur égale à environ λ/4n, de la couche réflectrice (306) et d'un second substrat (308) contre la seconde face (302) de la couche de matériau électriquement isolant (108), tels que la couche de matériau sacrificiel (304) soit disposée entre la couche réflectrice (306) et la couche de matériau électriquement isolant (108) et que la couche réflectrice (306) soit disposée entre la couche de matériau sacrificiel (304) et le second substrat (308) ;
- suppression de la poignée mécanique (204).

10. Procédé selon la revendication 9, dans lequel la couche de matériau électriquement isolant (108) est à base d'oxyde de semi-conducteur et la couche de matériau sacrificiel (304) est solidarisée à la couche de matériau électriquement isolant (108) par l'intermédiaire d'une deuxième couche de matériau électriquement isolant à base d'oxyde de semi-conducteur formée au préalable contre la couche de matériau de matériau sacrificiel (304).

11. Procédé selon l'une des revendications précédentes, comportant en outre, préalablement à la réalisation de l'ouverture (130) à travers la couche de matériau de matériau électriquement isolant (108), la réalisation d'un masque de gravure (128) sur la couche de matériau électriquement isolant (108) tel que des portions du masque de gravure (128) recouvrent des plots de connexion (122) reliés électriquement au ou aux pixels (110a, 110b).

12. Procédé selon l'une des revendications précédentes, comportant en outre, après l'élimination d'au moins une partie de la couche de matériau sacrificiel (106, 208, 304) à travers l'ouverture (130), le remplissage de la cavité optique (136) par au moins un gaz ou un matériau d'indice de réfraction égal à n, formant un milieu de la cavité optique (136).

13. Procédé selon l'une des revendications précédentes, dans lequel le matériau sacrificiel est du silicium et/ou du germanium, et/ou dans lequel la couche de matériau électriquement isolant (108) est à base d'oxyde de semi-conducteur.

14. Procédé selon l'une des revendications précédentes, dans lequel la couche réflectrice (104, 210, 306) comporte un empilement d'au moins une couche d'arrêt de gravure à base d'un matériau apte à résister à un agent de gravure utilisé lors de l'élimination d'au moins une partie de la couche de matériau sacrificiel (106, 208, 304) et d'au moins une couche réfléchissante, la couche d'arrêt de gravure étant disposée entre la couche réfléchissante et la couche de matériau sacrificiel (108).

15. Procédé selon la revendication 13, dans lequel la couche d'arrêt de gravure est à base d'oxyde de semi-conducteur et/ou la couche réfléchissante est à base d'aluminium.

16. Procédé selon l'une des revendications précédentes, dans lequel l'onde électromagnétique comporte une longueur d'onde λ comprise entre environ 0,5 THz et 10 THz, ou entre environ 0,5 THz et 1,5 THz.
